# FASCICULE DE BREVET EUROPEEN

(11) **EP 2 454 550 B1**
(45) Date de publication et mention de la délivrance du brevet: **04.09.2013**
(21) Numéro de dépôt: 10737812.7
(22) Date de dépôt: 08.07.2010
(51) Int. Cl.: F28F 3/02, H01L 23/367, B21D 53/04

(54) **DISSIPATEUR THERMIQUE POUR UN COMPOSANT ELECTRONIQUE OU ELECTRIQUE**
KÜHLKÖRPER FÜR EINE ELEKTRONISCHE ODER ELEKTRISCHE BAUGRUPPE
HEATSINK FOR AN ELECTRIC OR ELECTRONIC COMPONENT

(30) Priorité: 14.07.2009 BE 200900429
(43) Date de publication de la demande: 23.05.2012
(73) Titulaire: Verplaetse, Daniel, 6530 Thuin (BE); Konstantatos, Nicolas, 6536 Thuillies (BE)
(72) Inventeur: MOLLE, Franz, BE-7110 Strepy-bracquegnies (BE)
(74) Mandataire: Plucker, Guy
(86) Numéro de dépôt international: PCT/EP2010/059782
(87) Numéro de publication internationale: WO 2011/006819

(56) Documents cités:
- US-A1- 2001 037 571
- US-A1- 2007 206 357

## Description

### Domaine de l'invention

L'invention se rapporte à un dissipateur thermique pour un composant électrique ou électronique particulièrement efficace, facile et bon marché à produire. Il peut être utilisé pour tous types de composants électroniques, comme par exemple, des microprocesseurs ou des luminaires LED, ainsi que de composants électriques, comme par exemple, des transformateurs ou variateurs d'intensité.

### Arrière-plan technologique

Il existe de nombreux composants électroniques dans des domaines de plus en plus nombreux. On pense bien entendu à des microprocesseurs dans des machines ou des ordinateurs, mais également aux semi-conducteurs utilisés dans les luminaires, communément appelés LED (Light Emitting Diode). Tous ces composants électroniques ont en commun la génération de chaleur lors de leur utilisation. Malheureusement, leur efficacité et durée de vie sont fort dépendantes de la température (certains auteurs appliquent une loi d'Arrhenius pour modéliser la dépendance de la durée de vie d'un spot LED en fonction de la température). La chaleur générée par leur fonctionnement réduit donc leurs performances. Pour cette raison, il est nécessaire d'évacuer la chaleur générée par ces composants électroniques. On peut atteindre cet objectif par des moyens dynamiques, à l'aide par exemple d'un ventilateur, d'un échangeur de chaleur, ou par des moyens passifs, par exemple à l'aide d'un radiateur, aussi appelé dissipateur de chaleur, dissipateur thermique ou 'heat sink' en anglais, ces expressions étant considérées ici comme des synonymes.

De nombreux modèles de radiateurs sont disponibles sur le marché. Ils ont tous en commun des éléments constitués de matériaux à forte conduction thermique, tel que de l'aluminium, tungstène, titane, ou du cuivre, placés en contact thermique avec le composant électronique d'où la chaleur doit être évacuée, et ayant une géométrie permettant d'évacuer cette chaleur loin du composant. On peut citer par exemple des dissipateurs de chaleur comprenant un élément de base sur lequel est fixé le composant électronique et des éléments disposés radialement autour de cet élément de base permettant l'évacuation de la chaleur vers un anneau extérieur concentrique à l'élément de base. De tels dispositifs sont décrits par exemple dans US7153004 et WO2006/118457.

Pour pallier à des problèmes d'encombrement radial excessif, d'autres radiateurs comprennent des ailettes ou des tiges s'étendant hors du plan de l'élément de base, évacuant la chaleur vers l'arrière du composant électronique. Les ailettes peuvent être disposées autour du périmètre de l'élément de base, comme dans US 2001/037571 ou dans WO2008/135927, ou disposés sur toute la superficie de l'élément de base comme dans US2007/0036161, US7108055, US6826050, WO2006/017301, et WO2008/005833. La forme des ailettes varie du simple rectangle à des géométries tridimensionnelles. Dans US2005/0257914 l'élément de base est relié à un corps creux s'étendant sur un plan normal au premier, sur lequel sont fixées des ailettes.

Les dissipateurs de chaleur revus ci-dessus sont de complexité et d'efficacité variables mais demandent tous des moyens de mise en oeuvre onéreux ou longs. En effet, ils sont soit coulés dans un moule en une pièce, soit extrudés ou, alternativement, requièrent l'assemblage de différentes pièces. US5660461 décrit un dissipateur de chaleur constitué d'éléments individuels destinés à être assemblés pour former une matrice permettant d'évacuer la chaleur d'une batterie de LED. Dans une variante, chaque élément individuel dudit dissipateur est formé par découpage d'une bande de métal et pliage de celle-ci en 'U' formant ainsi deux ailettes reliées à un élément de base. Les 'U' sont alors assemblés en bandes, ou en matrices. Ici encore, le travail manuel est important et lesdits dissipateurs ne s'appliquent qu'à des produits spécifiques comprenant une multitude de LED's.

Il demeure donc un besoin en dissipateurs de chaleur pour composants électroniques permettant de maintenir la température du composant électronique à des niveaux les plus bas possible, et qui soient faciles et bon marché à fabriquer dans des configurations géométriques et des quantités variées.

### Résumé de l'invention

La présente invention est définie dans les revendications indépendantes ci-jointes. Des variantes préférées sont définies dans les revendications dépendantes. La présente invention concerne un dissipateur thermique pour un composant électronique ou électrique, comprenant :
- un élément de base, de préférence plat, comprenant une première face principale appropriée pour recevoir en contact thermique intime le composant électronique ou électrique;
- une pluralité d'ailettes allongées ressortant vers l'extérieur de la deuxième face principale de l'élément de base, opposée à la première face, et disposées autour de la périphérie entière de l'élément de base avec un espace entre deux ailettes permettant la circulation de l'air, les ailettes étant en outre disposées selon au moins deux figures géométriques régulières concentriques avec leurs faces principales sécantes ou sensiblement tangentes auxdites figures, et les ailettes ayant une forme trapézoïdale dont le côté court est en contact avec ledit élément de base .
   Ledit dissipateur thermique est obtenu en
- coupant dans une plaque mince une forme géométrique correspondant audit élément de base plat et auxdites ailettes; et en
- pliant les ailettes par rapport au plan de l'élément de base.

L'invention concerne aussi un procédé de fabrication d'un dissipateur thermique pour composants électroniques, comprenant les étapes suivantes :
- couper dans une plaque mince une forme géométrique correspondant à un élément de base et à une pluralité d'ailettes allongées présentant une forme trapézoïdale dont le côté court est en contact avec ledit élément de base ;
- plier les ailettes hors du plan de la plaque, de sorte que les ailettes sont disposées selon au moins deux figures géométriques régulières concentriques autour de la périphérie entière de l'élément de base avec un espace entre deux ailettes permettant une circulation d'air.

Par ailette de forme trapézoïdale selon l'invention, il faut entendre dans la présente demande toute forme d'ailette comprenant une figure géométrique sensiblement trapézoïdale dont le côté court est en contact avec ledit élément de base.
L'ailette de forme trapézoïdale est donc plus large à mesure qu'augmente la hauteur de ladite figure et que la différence de température (ΔT) entre l'air et l'ailette diminue afin d'assurer une dissipation thermique sensiblement constante sur toute la hauteur de ladite figure. La forme de l'ailette contribue par conséquent à maximiser la dissipation thermique par unité de volume du dissipateur.

La surface d'échange et donc l'effet de refroidissement du dissipateur thermique selon l'invention sont maximisés à la fois par un nombre suffisant d'ailettes et par la grande surface d'échange de chaque ailette de forme trapézoïdale.
En raison de leur forme, les ailettes peuvent être découpées d'une plaque mince en un nombre particulièrement important si leurs faces en contact avec l'élément de base se trouvent avantageusement sur des figures géométriques régulières courbes telles que des ellipses ou des cercles.
Toujours en raison de leur forme particulière et de leur nombre, deux ailettes adjacentes ne peuvent être pliées (selon un même angle) sans se recouvrir partiellement, que si les faces de ces ailettes en contact avec l'élément de base sont décalées sur des figures régulières concentriques après leur pliage successif ou en séquence.

La présente invention est particulièrement utile dans le domaine des lampes à diodes, dites LED, ainsi que dans les microprocesseurs utilisés dans des ordinateurs ou des machines. En général, un dissipateur de chaleur selon la présente invention permet de maintenir la température d'un composant électronique, tel un semi-conducteur, à des niveaux inférieurs à ce que la plupart des radiateurs du marché ne le permettent, ce qui augmente sensiblement la durée de vie dudit composant.

### Brève description des figures

Ces aspects ainsi que d'autres aspects de l'invention seront clarifiés dans la description détaillée de modes de réalisation particuliers de l'invention, référence étant faite aux figures, dans lesquelles :
- Fig. 1(a) à (h): montre un dissipateur thermique selon la présente invention, à différents stades de sa fabrication depuis l'état déployé avant pliage à sa configuration finale après pliage avec des vues, en perspective ou non, de face, de haut et de dessous.
- Fig. 2 :: (a) spot LED monté sur un dissipateur de l'art antérieur ; et (b) le même spot monté sur un dissipateur selon l'invention, utilisés pour l'exemple comparatif.
- Fig. 3:: représentation graphique de la température en fonction du temps mesurée sur des spots LED montés sur un dissipateur de la présente invention et de l'art antérieur.
- Fig. 4 :: montre des formes de réalisation de la forme d'ailette du dissipateur thermique selon l'invention.

### Description détaillée de modes de réalisation particuliers

Les Figures la à g montre différentes vues d'un dissipateur thermique selon la présente invention à différents stades successifs de sa fabrication. Le principe de sa fabrication est extrêmement simple puisqu'il suffit de se procurer une plaque mince en matériau conducteur, tel de l'aluminium, du cuivre, du tungstène ou du titane ou d'autre métaux ou alliages, et d'en retirer comme à la Fig. la une géométrie comprenant une partie centrale qui définit un élément de base 2 du dissipateur thermique, d'où rayonnent des ailettes 3 formant une sorte d'étoile dont la géométrie dépend de la configuration désirée du dissipateur. Sur cette dernière figure sont également représentés deux cercles concentriques 4' et 4" selon lesquels les ailettes 3 seront pliées dans un stade ultérieur, le cercle 4" se trouvant à l'extérieur du premier. Une plaque mince adaptée à la présente invention peut être obtenue facilement et à bon marché sur le marché et est produite par exemple par laminage. Ladite plaque peut présenter sur ses surfaces des textures telles que des boursouflures, rainures, stries, guillochis, saillies, protubérances etc. afin d'augmenter la surface d'échange des ailettes. La forme en 'étoile' de la plaque peut être obtenue par tout moyen bien connu de l'homme du métier, comprenant par exemple, l'estampage, la découpe par faisceau laser ou l'usinage photochimique. La découpe par faisceau laser est particulièrement préférée dans le cas de production en petites séries, où la géométrie de l'étoile peut être amenée à changer régulièrement.

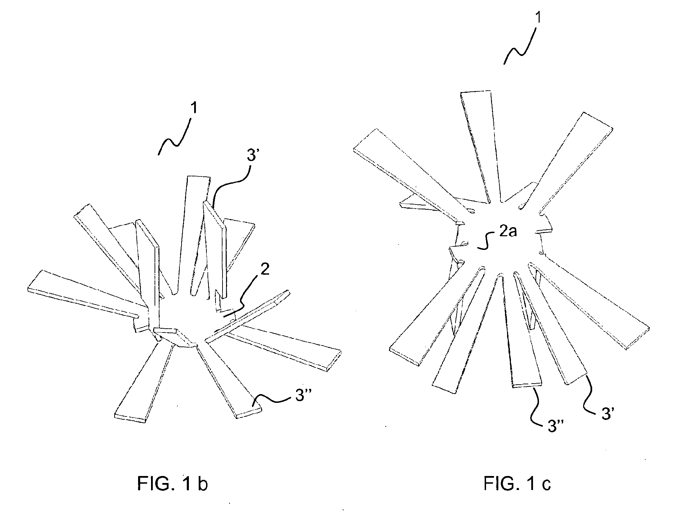

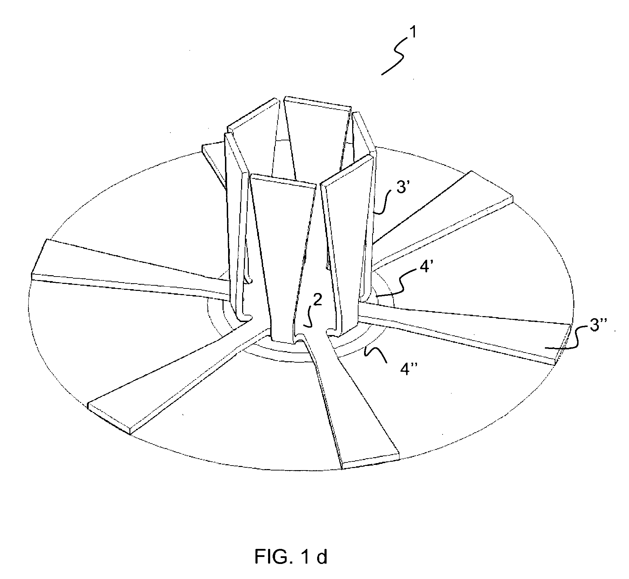

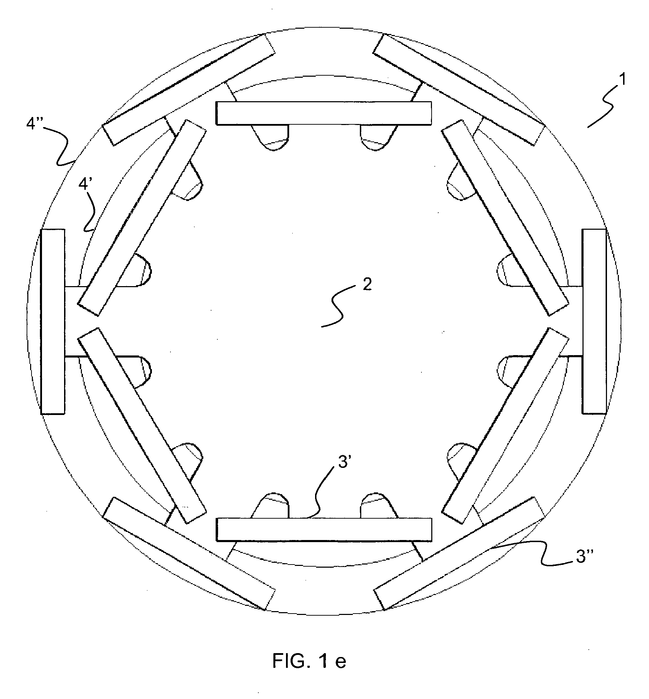

Comme on peut le voir sur les Figures 1(b) et (c) un premier groupe de six ailettes non adjacentes 3' sont en cours de pliage sur un angle d'environ 90° et selon le cercle 4' tandis qu'un second groupe de six ailettes non adjacentes 3" sont maintenues dans le plan de l'élément de base 2. La Fig. 1d montre les ailettes 3' après leur pliage selon le cercle 4'. Quant aux Fig. 1e à h, elles représentent le dissipateur thermique 1 après pliage du second groupe d'ailettes 3" selon le cercle 4". On peut y voir que le décalage radial entre les deux groupes d'ailettes favorise la circulation d'air et donc leur refroidissement. L'ensemble des ailettes 3 forme une couronne autour du périmètre de l'élément de base 2, assez similaire en géométrie à celle représentée dans WO2008/135927 mais présentant une bien plus grande densité d'ailettes chacune de surface supérieure, et étant en outre produite à un coût bien inférieur par le procédé de la présente invention. Sur la Fig. 1e en particulier, l'on voit clairement que les faces des ailettes 3 (3' et 3") en contact avec l'élément de base 2 sont sécantes par rapport respectivement aux cercles 4' et 4" . Lesdites faces peuvent aussi être tangentielles à ces cercles. L'élément de base 2 peut être de dimensions aptes à accueillir un seul composant électronique, ou plusieurs. Il comprend généralement une section plane permettant d'assurer un contact thermique optimal avec le composant électronique, mais selon les applications l'élément de base peut parfaitement avoir une géométrie tridimensionnelle.

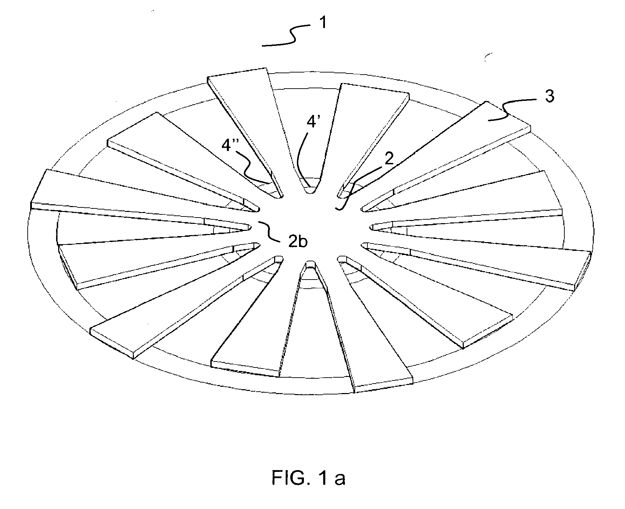

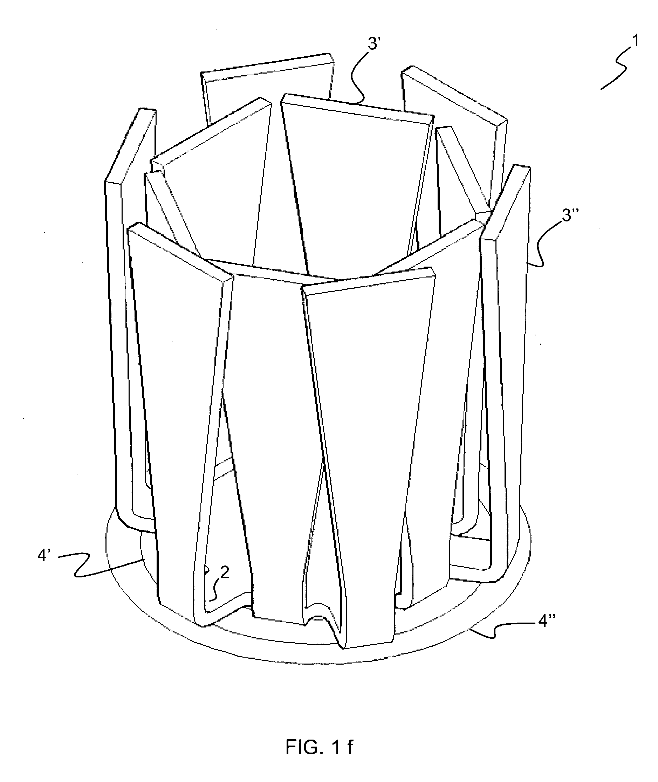

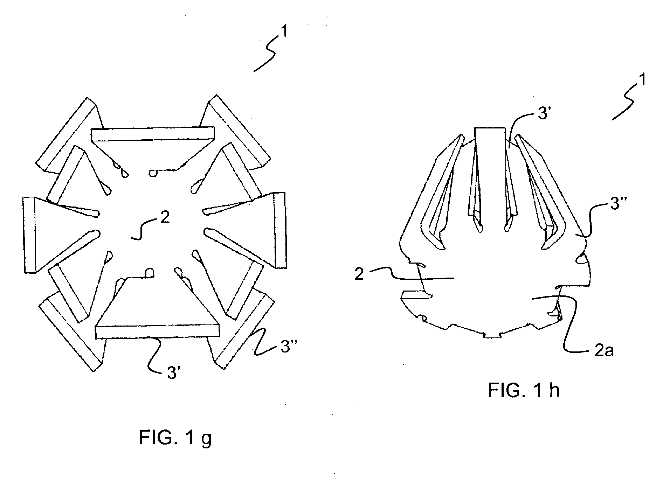

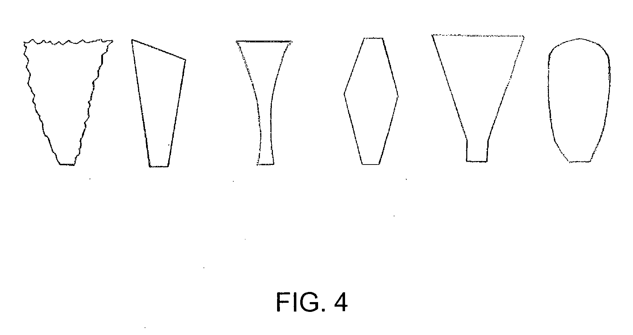

Selon l'invention, les ailettes 3 ont une forme trapézoïdale dont le côté court est en contact avec l'élément de base 2 de sorte que des ouvertures triangulaires s'interposent entre deux ailettes pour permettre une circulation d'air (voir Figure 1).. Des formes de réalisation correspondantes de l'ailette sont visibles à la Fig.4.

D'autres formes de réalisation peuvent bien entendu être employées. Par exemple les bords latéraux des ailettes ne sont pas nécessairement droits et peuvent comprendre au moins une section courbe. De même des orifices peuvent être disposés le long des ailettes pour favoriser la circulation d'air et diminuer la masse thermique du dissipateur.
Par ailleurs, les ailettes peuvent avoir leur partie supérieure repliée vers l'intérieur ou l'extérieur afin de réduire leur encombrement et ainsi d'augmenter la capacité du dissipateur thermique par unité de volume.

Le pliage des ailettes peut se faire manuellement, mais il est avantageux d'utiliser un outil comprenant une cavité de géométrie adéquate, de placer la plaque découpée en étoile au-dessus de celle-ci et, à l'aide d'un piston, d'enfoncer le centre de l'étoile qui formera l'élément de base (2) au fond de la cavité et ainsi par cette action relever les ailettes (3) à l'angle désiré. L'angle de pliage des ailettes est compris de préférence entre 0 et 120 degrés, et de façon plus préférée entre 30 et 90°, le choix de l'angle étant souvent déterminé par la configuration géométrique de l'endroit où le composant électronique doit être placé. Un angle de 90 degrés permet d'introduire de manière réversible le dispositif dans une enceinte cylindrique. Ce genre de configuration se présente souvent dans le cas de luminaires LED. Si par contre le mode de montage du composant le permet, un angle inférieur à 90 degrés, permet de dégager la chaleur de manière plus efficace puisque chaque ailette s'écarte de ses voisines et ne subit plus leur chaleur. Un angle supérieur à 90°, bien que rapprochant les ailettes, peut faciliter par exemple le passage d'un câble d'alimentation vers le composant à refroidir. Un angle inférieur à 30°, bien que moins favorable sur le plan de la circulation de l'air (convection naturelle), peut néanmoins présenter un intérêt d'ordre esthétique.
En plus des ailettes 3, d'autres moyens de refroidissement peuvent être prévus dans des orientations identiques ou différentes des ailettes 3.

Le procédé selon l'invention peut comprendre après le découpage de l'élément de base 2 et des ailettes 3 dans la plaque mince, les étapes suivantes :
- répartir les ailettes 3 en n groupes d'ailettes non adjacentes, n étant un nombre entier supérieur ou égal à 2 ;
- plier les ailettes 3 en séquence par groupe hors du plan de la plaque d'abord celles d'un premier groupe 3' selon une première ellipse 4', ensuite les ailettes d'un deuxième groupe 3" selon une deuxième ellipse concentrique 4" extérieure à la première, et finalement les ailettes d'un nième groupe selon une nième ellipse concentrique extérieure à la précédente.
Cette forme de réalisation du procédé est visible aux Fig.1a à h, dans lesquelles les ellipses sont des cercles et n est égal à 2.

Après leur pliage, les ailettes peuvent en outre être tordues afin d'être mises dans la configuration souhaitée.

Ce procédé de production permet une automatisation du mode de fabrication des dissipateurs de chaleur de la présente invention et permet d'atteindre des rythmes de production supérieurs à la plupart des procédés de production de dissipateurs de l'art antérieur. De plus les outils nécessaires à cette opération sont beaucoup moins onéreux que des moules de coulage.

Le composant électronique, dont la chaleur générée pendant son utilisation doit être évacuée, peut être intégré à la première face principale 2a de l'élément de base 2 par tout moyen connu de l'homme du métier, tant que le contact assure une conduction thermique suffisante pour que la chaleur générée soit transférée vers le dissipateur. Par exemple, le composant électronique peut être collé avec des adhésifs adéquats à haute conduction thermique. De manière alternative, le composant peut être fixé à l'élément de base 2 par soudage ou brasage, par vis, par laser ou toute autre technique connue, en prenant garde de ne pas endommager le composant électronique par un chauffage excessif lors de la fixation.

Tout composant électronique ou électrique nécessitant l'évacuation de la chaleur générée par sa propre utilisation peut être fixé au dissipateur de la présente invention. En particulier, les semi-conducteurs utilisés comme microprocesseurs dans des ordinateurs ou machines de tout type. Un domaine d'application où le dissipateur de la présente invention est particulièrement intéressant est le domaine des luminaires LED. En l'absence de mesures spéciales pour évacuer la chaleur générée par un LED lors de son utilisation, la température du LED peut atteindre des températures supérieure à 100 °C, ce qui endommage irrémédiablement le LED et réduit de manière conséquente sa durée de vie.

### Exemple 1

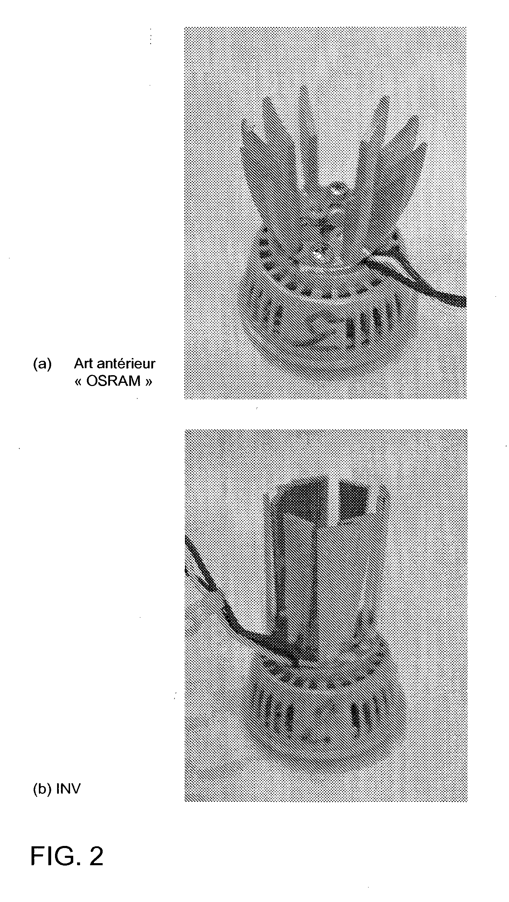

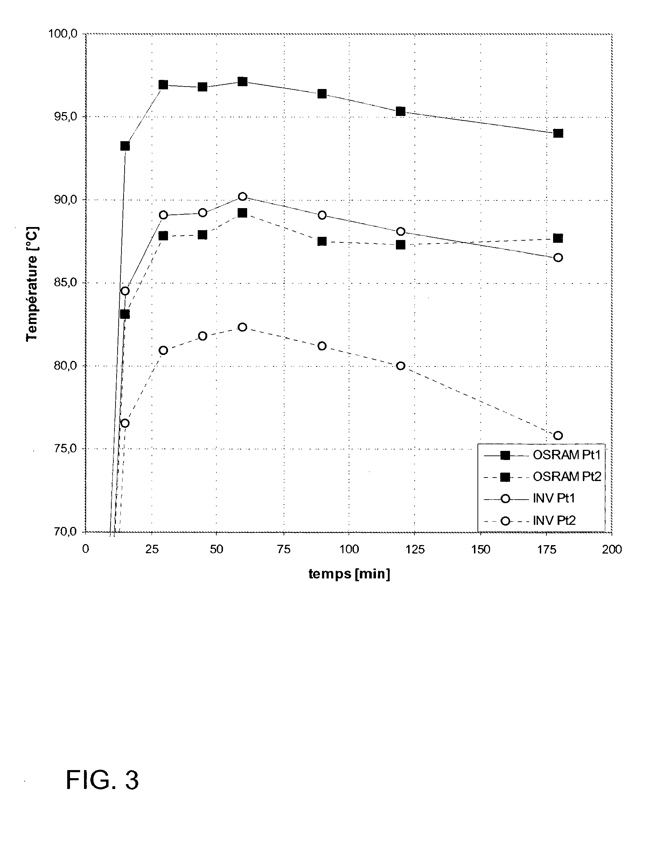

Deux spots LED du type COINlight-OSTAR CO06A commercialisés par la société OSRAM ont été testés de la manière suivante. Le premier spot, indiqué sous la référence "OSRAM", est connecté au réseau et est monté sur le dissipateur de chaleur d'origine livré avec le spot lors de son achat (voir Figure 2(a)). Le second spot, indiqué sous la référence "INV", est connecté au réseau par la même alimentation (OSRAM OT75/220-240/24) que le spot "OSRAM" et comprend un dissipateur de chaleur selon la présente invention, tel que représenté sur les Figures 1(a) et 2(b). La température a été mesurée à l'aide de thermocouples placés en deux points sur chaque spot : au point Pt1, situé en contact avec le module LED, et au point Pt2, situé entre les rainures d'aération, juste au-dessus de la seconde face (2b) de l'élément de base 2. Le test a été réalisé dans une véranda entre 13h00 et 16h00 et la température ambiante a été mesurée 50 cm devant les spots. Les résultats de ce test sont reportés sur le Tableau ci-dessous et représentés graphiquement sur la Figure 3.

| **temps [min]** | **température [°C]** | | | | | | |
|---|---|---|---|---|---|---|---|
| | **ambiante** | **Pt1** | | | **Pt2** | | |
| | | **OSRAM** | **INV** | **INV-OSRAM** | **OSRAM** | **INV** | **INV-OSRAM** |
| 15 | 32,1 | 93,2 | 84,5 | -8,7 | 83,1 | 76,5 | -6,6 |
| 30 | 33,2 | 96,9 | 89,1 | -7,8 | 87,8 | 80,9 | -6,9 |
| 45 | 38,9 | 96,8 | 89,2 | -7,6 | 87,9 | 81,8 | -6,1 |
| 60 | 41,2 | 97,1 | 90,2 | -6,9 | 89,2 | 82,3 | -6,9 |
| 90 | 38,5 | 96,4 | 89,1 | -7,3 | 87,5 | 81,2 | -6,3 |
| 120 | 35,2 | 95,3 | 88,1 | -7,2 | 87,3 | 80 | -7,3 |
| 180 | 33,3 | 94,0 | 86,5 | -7,5 | 87,7 | 75,8 | -11,9 |
| **moyenne** | **36,1** | **95,7** | **88,1** | **-7,6** | **87,2** | **79,8** | **-7,4** |

On observe que la température aux points Pt1 et Pt2 est environ 7,5°C inférieure avec un dissipateur selon la présente invention qu'avec le dissipateur d'origine des spots testés et surtout que la température maximale atteinte au niveau du LED (Pt1) avec le dissipateur de la présente invention dépasse à peine les 90°C, alors qu'avec le dissipateur d'origine, une température de 97,1°C est atteinte, avec une température supérieure à 95°C pendant plus d'une heure et demie. Cette réduction substantielle de la température permet de prolonger de manière conséquente la durée de vie des spots.

### Exemple 2

Un dissipateur thermique selon l'invention a été comparé avec un dissipateur de l'état de la technique présentant des ailettes rectangulaires de même hauteur pliées autour d'un élément de base de surface équivalente, sur le plan de leur surface d'échange. Celle du dissipateur thermique selon l'invention était de l'ordre de 60 % supérieure.

On peut donc conclure qu'un dissipateur selon la présente invention comporte les avantages suivants:
- grande efficacité d'évacuation de la chaleur ce qui augmente de manière considérable la durée de vie d'un composant électronique;
- forte compacité du dissipateur thermique par la grande capacité de dissipation par unité de volume du dissipateur ;
- légèreté du dissipateur, ce qui entraîne des économies conséquentes en termes de matériaux;
- matériau de départ sous forme de plaques minces disponibles à la vente à bon marché et sans limitation en quantité;
- procédé de fabrication simple, bon marché, ne requérant pas d'équipement particulièrement onéreux et adapté tant aux grands, qu'aux petits volumes de production;
- permet une grande liberté dans le design du dissipateur, selon l'application désirée et les contraintes spatiales à respecter.
- Permet d'éviter les bulles d'air, de nature isolante thermiquement, présentes dans la plupart des pièces en aluminium moulées ou extrudées.

## Revendications

1. Dissipateur thermique (1) pour un composant électronique ou électrique, comprenant :
- un élément de base (2) comprenant une première face principale (2a) appropriée pour recevoir en contact thermique intime le composant électronique ;
- une pluralité d'ailettes (3) allongées ressortant vers l'extérieur de la deuxième face principale (2b) de l'élément de base (2), opposée à la première face (2a), et disposées autour de la périphérie entière de l'élément de base avec un espace entre deux ailettes permettant la circulation de l'air,
**caractérisé en ce que** :
- les ailettes étant en outre disposées selon au moins deux figures géométriques régulières concentriques (4',4" ) avec leurs faces principales sécantes ou sensiblement tangentes auxdites figures;
- les ailettes ont une forme trapézoïdale dont le côté court est en contact avec ledit élément de base (2) ; et **en ce que**
- le dissipateur thermique est obtenu en
- coupant dans une plaque mince une forme géométrique correspondant audit élément de base et auxdites ailettes; et
- pliant les ailettes par rapport au plan de l'élément de base.

2. Dissipateur thermique selon la revendication 1, **caractérisé en ce que** les ailettes sont pliées selon un angle de 0° à 120°.

3. Dissipateur thermique selon la revendication 2, **caractérisé en ce que** ledit angle est de 30° à 90°.

4. Dissipateur thermique selon l'une quelconque des revendications précédentes, **caractérisé en ce qu'**il peut être obtenu en tordant les ailettes (3) après leur pliage.

5. Dissipateur thermique selon l'une quelconque des revendications précédentes, **caractérisé en ce que** lesdites au moins deux figures géométriques régulières concentriques (4',4" ) sont des ellipses ou des cercles.

6. Dissipateur thermique selon l'une quelconque des revendications 1 à 4, **caractérisé en ce que** lesdites au moins deux figures géométriques régulières concentriques (4',4") sont des polygones.

7. Dissipateur thermique selon l'une quelconque des revendications précédentes, **caractérisé en ce que** les ailettes (3) ont leur partie supérieure repliée vers l'intérieur ou l'extérieur.

8. Dissipateur thermique selon l'une quelconque des revendications précédentes, **caractérisé en ce que** la plaque mince est produite par laminage.

9. Dissipateur thermique selon l'une quelconque des revendications précédentes, **caractérisé en ce que** la plaque mince est constituée d'aluminium, de tungstène, de titane, ou de cuivre.

10. Dissipateur thermique selon l'une quelconque des revendications précédentes, comprenant un composant électronique ou électrique en contact thermique intime avec la première surface principale (2a) de l'élément de base (2), ledit composant électronique étant sélectionné parmi les semi-conducteurs en général, et en particulier les microprocesseurs, et les lampes à diode (LED), et le composant électrique étant sélectionné parmi les transformateurs et les variateurs d'intensité.

11. Procédé de fabrication d'un dissipateur thermique (1) pour composants électroniques ou électriques, comprenant les étapes suivantes :
- couper dans une plaque mince une forme géométrique correspondant à un élément de base (2) et à une pluralité d'ailettes allongées (3) présentant une forme trapézoïdale dont le côté court est en contact avec ledit élément de base (2) ;
- plier les ailettes (3) hors du plan de la plaque, de sorte que les ailettes sont disposées selon au moins deux figures géométriques régulières concentriques, avec leurs faces principales sécantes ou sensiblement tangentes auxdites figures, autour de la périphérie entière de l'élément de base avec un espace entre deux ailettes permettant une circulation d'air.

12. Procédé selon la revendication 11, **caractérisé en ce que** les ailettes sont pliées selon un angle de 0° à 120°.

13. Procédé selon la revendication 12, **caractérisé en ce que** ledit angle est de 30° à 90°.

14. Procédé selon l'une quelconque des revendications 11 à 13, **caractérisé en ce qu'**il comprend après le découpage desdites formes géométriques dans la plaque mince, les étapes suivantes :
- répartir les ailettes en n groupes d'ailettes non adjacentes, n étant un nombre entier supérieur ou égal à 2 ;
- plier les ailettes (3) en séquence par groupe hors du plan de la plaque, d'abord celles d'un premier groupe (3') selon une première ellipse (4'), ensuite les ailettes d'un deuxième groupe (3") selon une deuxième ellipse concentrique (4") extérieure à la première, et finalement les ailettes d'un nième groupe selon une nième ellipse concentrique extérieure à la précédente.

15. Procédé selon la revendication 14, **caractérisé en ce que** n est égal à 2.

16. Procédé selon la revendication 14 ou 15, **caractérisé en ce que** les ellipses (4', 4") sont des cercles.

17. Procédé selon l'une quelconque des revendications 11 à 16, **caractérisé en ce qu'**il comprend l'étape de tordre les ailettes (3) après leur pliage.

18. Procédé selon l'une quelconque des revendications 11 à 17, **caractérisé en ce que** l'étape de découpe est effectuée par estampage, faisceau laser ou usinage photochimique.

19. Procédé selon l'une quelconque des revendications 11 à 18, **caractérisé en ce que** l'étape de pliage est effectuée en plaçant la plaque découpée au-dessus d'une cavité ayant la géométrie désirée et estamper dans ladite cavité à l'aide d'un piston afin d'enfoncer l'élément de base au fond de la cavité et ainsi relever les ailettes à l'angle désiré.

## Patentansprüche

1. Wärmesenke (1) für elektronisches oder elektrisches Bauelement, umfassend:
- ein Basiselement (2), das eine erste Hauptseite (2a) umfasst, die dazu geeignet ist, um das elektronische Bauelement in engem thermischen Kontakt aufzunehmen;
- eine Vielzahl länglicher Flügel (3), die von der zweiten Hauptseite (2b) des Basiselements (2), die der ersten Seite (2a) gegenüberliegt, nach außen heraustreten und um den gesamten Umfang des Basiselements herum mit einem Zwischenraum zwischen zwei Flügeln, der den Umlauf von Luft ermöglicht, angeordnet sind,
**dadurch gekennzeichnet, dass**:
- die Flügel ferner in mindestens zwei konzentrischen regelmäßigen geometrischen Figuren (4', 4") angeordnet sind, wobei sich ihre Hauptseiten mit den Figuren schneiden oder diese im Wesentlichen berühren;
- die Flügel eine Trapezform aufweisen, deren kurze Seite mit dem Basiselement (2) in Berührung steht; und dass
- die Wärmesenke erzielt wird durch
- Ausschneiden einer geometrischen Form, die dem Basiselement und den Flügeln entspricht, aus einer dünnen Platte; und
- Biegen der Flügel im Verhältnis zur Ebene des Basiselements.

2. Wärmesenke nach Anspruch 1, **dadurch gekennzeichnet, dass** die Flügel in einem Winkel von 0° bis 120° gebogen sind.

3. Wärmesenke nach Anspruch 2, **dadurch gekennzeichnet, dass** der Winkel 30° bis 90° beträgt.

4. Wärmesenke nach einem der vorhergehenden Ansprüche, **dadurch gekennzeichnet, dass** er erzielt werden kann, indem die Flügel (3) nach Biegen derselben verdreht werden.

5. Wärmesenke nach einem der vorhergehenden Ansprüche, **dadurch gekennzeichnet, dass** die mindestens zwei konzentrischen regelmäßigen geometrischen Figuren (4', 4'') Ellipsen oder Kreise sind.

6. Wärmesenke nach einem der Ansprüche 1 bis 4, **dadurch gekennzeichnet, dass** die mindestens zwei konzentrischen regelmäßigen geometrischen Figuren (4', 4'') Vielecke sind.

7. Wärmesenke nach einem der vorhergehenden Ansprüche, **dadurch gekennzeichnet, dass** der obere Teil der Flügel (3) nach innen oder nach außen umgebogen ist.

8. Wärmesenke nach einem der vorhergehenden Ansprüche, **dadurch gekennzeichnet, dass** die dünne Platte durch Walzen erzeugt wird.

9. Wärmesenke nach einem der vorhergehenden Ansprüche, **dadurch gekennzeichnet, dass** die dünne Platte aus Aluminium, Wolfram, Titan oder Kupfer besteht.

10. Wärmesenke nach einem der vorhergehenden Ansprüche, umfassend ein elektronisches oder elektrisches Bauelement in engem thermischen Kontakt mit der ersten Hauptfläche (2a) des Basiselements (2), wobei das elektronische Bauelement aus den Halbleitern allgemein und insbesondere aus den Mikroprozessoren und den Leuchtdioden (LED) ausgewählt wird, und das elektrische Bauelement aus den Transformatoren und Dimmern ausgewählt wird.

11. Verfahren zum Herstellen einer Wärmesenke (1) für elektronische oder elektrische Bauelemente, umfassend folgende Schritte:
- Ausschneiden einer geometrischen Form, die dem Basiselement (2) und einer Vielzahl länglicher Flügel (3) entspricht, die eine Trapezform aufweisen, deren kleine Seite in Kontakt mit dem Basiselement (2) steht, aus einer dünnen Platte; und
- Biegen der Flügel (3) aus der Ebene der Platte heraus, so dass die Flügel in mindestens zwei konzentrischen regelmäßigen geometrischen Figuren, wobei sich ihre Hauptseiten mit den Figuren schneiden oder diese im Wesentlichen berühren, um den gesamten Umfang des Basiselements herum mit einem Zwischenraum zwischen zwei Flügeln, der den Umlauf von Luft ermöglicht, angeordnet sind.

12. Verfahren nach Anspruch 11, **dadurch gekennzeichnet, dass** die Flügel in einem Winkel von 0° bis 120° gebogen sind.

13. Verfahren nach Anspruch 12, **dadurch gekennzeichnet, dass** der Winkel 30° bis 90° beträgt.

14. Verfahren nach einem der Ansprüche 11 bis 13, **dadurch gekennzeichnet, dass** es nach dem Ausschneiden der geometrischen Formen aus der dünnen Platte die folgenden Schritte umfasst:
- Verteilen der Flügel auf n nicht angrenzende Flügelgruppen, wobei n eine Ganzzahl ist, die größer oder gleich 2 ist;
- Biegen der Flügel (3) der Reihe nach in Gruppen aus der Ebene der Platte heraus, und zwar zuerst die einer ersten Gruppe (3') zu einer ersten Ellipse (4'), dann die Flügel einer zweiten Gruppe (3 ") zu einer zweiten konzentrischen Ellipse (4 ") außerhalb der ersten, und schließlich die Flügel einer n. Gruppe zu einer n. konzentrischen Ellipse außerhalb der vorhergehenden.

15. Verfahren nach Anspruch 14, **dadurch gekennzeichnet, dass** n gleich 2 ist.

16. Verfahren nach Anspruch 14 oder 15, **dadurch gekennzeichnet, dass** die Ellipsen (4', 4") Kreise sind.

17. Verfahren nach einem der Ansprüche 11 bis 16, **dadurch gekennzeichnet, dass** es den Schritt des Verdrehens der Flügel (3) nach Biegen derselben umfasst.

18. Verfahren nach einem der Ansprüche 11 bis 17, **dadurch gekennzeichnet, dass** der Schritt des Ausschneidens durch Stanzen, Laserstrahl oder photochemische Bearbeitung ausgeführt wird.

19. Verfahren nach einem der Ansprüche 11 bis 18, **dadurch gekennzeichnet, dass** der Schritt des Biegens ausgeführt wird, indem die ausgeschnittene Platte über einem Hohlraum platziert wird, der die gewünschte Geometrie aufweist, und in dem Hohlraum anhand eines Stempels ausgestanzt wird, um das Basiselement auf den Boden des Hohlraums zu drücken und somit die Flügel in dem gewünschten Winkel anzuheben.

## Claims

1. Heat sink (1) for an electronic or electrical component, comprising:
- a base element (2) comprising a first main surface (2a) suitable for receiving the electronic or electrical component in close thermal contact;
- a plurality of elongate fins (3) projecting outwards from the second main surface (2b) of the base element (2), opposite the first surface (2a), and arranged around the entire periphery of the base element with enough space between fins to allow air circulation,
**characterised in that**:
- the fins being further arranged according to at least two concentric regular geometric figures (4',4 ") with the main surfaces thereof secant or substantially tangent with respect to said figures;
- the fins have a trapezoidal shape wherein the short side is in contact with said base element (2); and **in that**
- the heat sink is obtained by
- cutting a geometric shape corresponding to said flat base element and said fins in a thin plate; and
- bending the fins relative to the plane of the base element.

2. Heat sink according claim 1, **characterised in that** the fins are bent along an angle of 0° to 120°.

3. Heat sink according to claim 2, **characterised in that** said angle is 30° to 90°.

4. Heat sink according to any of the above claims, **characterised in that** it can be obtained by twisting the fins (3) after bending.

5. Heat sink according to any of the above claims, **characterised in that** said at least two concentric regular geometric figures (4',4 ") are ellipses or circles.

6. Heat sink according to any of claims 1 to 4, **characterised in that** said at least two concentric regular geometric figures (4',4") are polygons.

7. Heat sink according to any of the above claims, **characterised in that** the upper portion of the fins (3) is bent inwards or outwards.

8. Heat sink according to any of the above claims, **characterised in that** the thin plate is produced by rolling.

9. Heat sink according to any of the above claims, **characterised in that** the thin plate consists of aluminium, tungsten, titanium, or copper.

10. Heat sink according to any of the above claims, comprising an electronic or electrical component in close thermal contact with the first main surface (2a) of the base element (2), said electronic component being selected from semiconductors in general, and particularly microprocessors, and light-emitting diodes (LEDs), and the electrical component being selected from transformers and current variators.

11. Method for manufacturing a heat sink (1) for electronic or electrical components, comprising the following steps:
- cutting a geometric shape corresponding to a base element (2) and a plurality of elongate fins (3) having a trapezoidal shape wherein the short side is in contact with said base element (2) in a thin plate;
- bending the fins (3) outside the plane of the plate, such that the fins are arranged according to at least two concentric regular geometric figures, with the main surfaces thereof secant or substantially tangent with respect to said figures, around the entire periphery of the base element with enough space between fins to allow air circulation.

12. Method according to claim 11, **characterised in that** the fins are bent along an angle of 0° to 120°.

13. Method according to claim 12, **characterised in that** said angle is 30° to 90°.

14. Method according to any of claims 11 to 13, **characterised in that** it comprises, after cutting said geometric shapes in the thin plate, the following steps:
- distributing the fins in n groups of non-adjacent fins, n being an integer greater than or equal to 2;
- bending the fins (3) in sequence by group outwards from the plane of the plate, first those of a first group (3') along a first ellipse (4'), then the fins from a second group (3") along a second concentric ellipse (4") outside the first, and finally the fins from an nth group along an nth concentric ellipse outside the preceding ellipse.

15. Method according to claim 14, **characterised in that** n is equal to 2.

16. Method according to claim 14 or 15, **characterised in that** the ellipses (4', 4") are circles.

17. Method according to any of claims 11 to 16, **characterised in that** it comprises the step for twisting the fins (3) after bending.

18. Method according to any of claims 11 to 17, **characterised in that** the cutting step is performed by stamping, a laser beam or photochemical machining.

19. Method according to any of claims 11 to 18, **characterised in that** the bending step is performed by positioning the cut plate above a cavity having the desired geometry and stamping in said cavity using a piston to depress the base element to the bottom of the cavity and thus raise the fins to the desired angle.
